# EUROPEAN PATENT APPLICATION

(11) **EP 4 417 455 A1**
(43) Date of publication of application: **21.08.2024**
(21) Application number: 23157563.0
(22) Date of filing: 20.02.2023
(51) Int. Cl.: B60L 3/00, B60L 53/14, B60L 53/30, B60L 58/21, B60L 53/10

(54) **MULTICHANNEL INSULATION MONITORING DEVICE FOR AN EVSE, AND METHOD**

(71) Applicant: ABB E-mobility B.V., 2629 JG Delft (NL)
(72) Inventor: RAAIJMAKERS, Stefan, 2613 WN Delft (NL); BECH, Lars Peter, 3119 JA Schiedam (NL); RODRIGUEZ ESCUDE, Miguel, 3111 PB Schiedam (NL); KOBIERSKI, Marianne, 3195 VM Pernis (NL)
(74) Representative: Maiwald GmbH

(57) **Abstract**

The invention relates to a Electric Vehicle Supply Equipment, EVSE, multichannel insulation monitoring device, MIMD, (400) for insulation monitoring or earth leakage current monitoring, wherein the EVSE multichannel insulation monitoring device (400) comprises multiple monitoring channels (411, 412) and wherein the EVSE multichannel insulation monitoring device (400) has control and monitor means (421, 422) configured to individually monitor the insulation or earth leakage current of each monitoring channel (411, 412).

## Description

### Technical Field

The invention relates to an multichannel insulation monitoring device (MIMD) for an Electric Vehicle Supply Equipment (EVSE) for insulation monitoring or earth leakage current monitoring, a method for insulation monitoring or earth leakage current monitoring, and the use of an multichannel insulation monitoring device.

### Background

Electric vehicles currently on the market charge a single battery through an AC connection, or through a single pair of DC pins. In order to decrease charging time or to provide redundancy, some electric vehicles are equipped with more than one on-board battery pack, which do not necessarily have the same voltage. EVs with more than one battery pack will require electric vehicle supply equipment (EVSE) that can charge one, some, or all of the on-board batteries at a time. Some standards require that all output circuits shall be individually equipped with a means of insulation monitoring or earth leakage current monitoring, between DC+, DC- and protective conductor.

This insulation monitoring is done, for example, during cable check, pre-charge and/or energy transfer depending on the system, such as Guobiao (GB) or Combined Charging System (CCS) systems, and by an earth leakage current measuring device for CHAdeMO systems. Typically, IMDs located in the EVSE or in the EV monitor DC bus channels by injecting a voltage and measuring to check that the measured voltage is the expected magnitude and phase. In some cases, if more than one IMD measurement voltage is injected on one channel, the resulting interference can result in unusable IMD measurements, and the channel will not be protected. Therefore, if a first IMD is monitoring one DC bus, and a second IMD is monitoring another bus, and if further an EV connects both buses to a single battery, then the two IMDs will inject measurement voltages into the same channel, which may cause interference.

### Summary

There may be a desire to provide an improved EVSE multichannel insulation monitoring device (MIMD) for insulation monitoring or earth leakage current monitoring.

The problem is solved by the subject-matter of the independent claims. Embodiments are provided by the dependent claims, the following description and the accompanying figures.

The described embodiments similarly pertain to the EVSE multichannel insulation monitoring device for insulation monitoring or earth leakage current monitoring, the method for insulation monitoring or earth leakage current monitoring, and the use of the EVSE multichannel insulation monitoring device. Synergetic effects may arise from different combinations of the embodiments although they might not be described in detail.

Further on, it shall be noted that all embodiments of the present invention concerning a method might be carried out with the order of the steps as described, nevertheless this has not to be the only and essential order of the steps of the method. The herein presented methods can be carried out with another order of the disclosed steps without departing from the respective method embodiment, unless explicitly mentioned to the contrary hereinafter.

Technical terms are used by their common sense. If a specific meaning is conveyed to certain terms, definitions of terms will be given in the following in the context of which the terms are used.

According to a first aspect, an EVSE multichannel insulation monitoring device (MIMD) for insulation monitoring or earth leakage current monitoring is provided. The EVSE multichannel insulation monitoring device comprises multiple monitoring channels and has control and monitor means configured to individually monitor the insulation or earth leakage current of each monitoring channel.

In this disclosure, the acronym IMD will be used to refer to the insulation monitoring or earth leakage current monitoring device used by any EVSE, and MIMD for the multichannel IMD as proposed in this disclosure.

"EVSE multichannel insulation monitoring device comprises multiple monitoring channels" expresses the capability of the MIMD to set up multiple monitoring channels. The monitoring channels may be activated for measuring and monitoring, or deactivated, depending on the current battery energy transfer configuration, i.e., the configuration depending on the connected battery energy transfer configuration The monitoring channels are controlled, i.e. activated or deactivated individually, which does not exclude a coordination between the channels.

The insulation monitoring may be provided by the MIMD with multiple monitoring channels or an EVSE insulation monitoring device comprising a single IMD with multiple measurements as described further below. Insulation monitoring on each individual bus is necessary when each bus is connected to a separate battery, as well as during cable check. The EV energy transfer session may have various phases, such as cable check and charging. The expression "EV energy transfer session" therefore covers these phases. Further, this expression covers also the energy transfer from the battery to the grid.

Electric vehicles comprise cars, trucks, buses, airplanes, boats, helicopters, drones, trains, transporters such as forklifts etc.

According to an embodiment, for individually monitoring the insulation or earth leakage current during a EV energy transfer session, the control and monitor means are configured to assign a monitoring channel of the multiple monitoring channels individually to a DC bus and to monitor each DC bus individually in case the battery configuration is such that each DC bus is connected to a separate battery or coordinated in case the battery configuration is such that more than one DC bus is connected to a single battery.

A DC bus is considered here including a DC+ line, a DC- line and the associated PE line. "Coordinated" means, for example, that only one of two, or generally n, where n is an integer greater than 1, buses that are connected to a single battery is monitored.

According to an embodiment, the EVSE multichannel insulation monitoring device has a battery energy transfer configuration detection interface for receiving information about the battery energy transfer configuration, wherein control and monitor means are further configured to determine the battery energy transfer configuration and select the monitoring channels according to the received information about the battery configuration.

The received information about the battery energy transfer configuration may be directly the configuration that is communicated e.g. by a communication means or indirectly, such that the control and monitor means has a means to derive the battery charging information from the received information based on which they can select the monitoring channels. The deriving means may include digital devices, logic devices such as logic gates, microprocessors, etc., and/or analog devices.

The battery energy transfer configuration may include the number of EVSE outlets, the number of EV inlets, the number of batteries, the number of DC buses between each of the outlets and each of the inlets, and the number of DC buses between each of the EV inlets and each of the batteries. Regarding the monitoring, it is sufficient that the control and monitor means determine the currently active configuration. "Currently active" means thereby that, for example, the EV changes the configuration according to, for example the state of charge of its batteries. The control and monitor means are adapted to recognize the change of configuration, to determine the new configuration and to change the selection accordingly if required.

According to an embodiment, the receiving information may be obtained as control commands, communication signals, detector signals and/or sensor signals.

According to an embodiment, the control and monitor means are configured, in case the control and monitor means have determined a configuration with more than one DC bus connected to a battery for charging the battery, to coordinate the monitoring between the channels.

When more than one DC bus is connected to a battery, interference may occur. Therefore, the monitoring has to be coordinated. This may be done, for example, by selecting one channel at a time.

According to an embodiment, the coordinating of the monitoring between the channels includes selecting one of the monitoring channels for monitoring one of the DC buses.

As one option for coordinating, the control and monitoring device is configured to select only one monitoring channel. That is, for example, a first monitoring channel is assigned to a first DC bus, and a second monitoring channel is assigned to a second DC bus. Both buses are connected to one battery. In this case, one of the monitoring channels is activated or remains active and the other is deactivated or remains inactive so that an interference is impeded.

According to an embodiment, the configuration detection interface is an interface to a controller, a communication unit, an interference detector and/or sensor, wherein the controller, the communication unit, the interference detector and/or the sensor are external to the EVSE multichannel insulation monitoring device.

In other words, the devices such as detectors, sensors, or the communication unit that are capable of detecting the battery configuration or of providing information by communication with, e.g. an internal communication unit may be outside of the EVSE multichannel insulation monitoring device. In this case, the information is received at the interface, which provides the information to the control and monitor means of the EVSE multichannel insulation monitoring device.

The communication unit may provide information, e.g. on a communication layer above the physical layer. A controller may send signals or commands using a low-level signal such as physical signals with two or more voltage or current levels.

According to an embodiment, the EVSE multichannel insulation monitoring device comprises further an internal communication unit for communicating with the external communicating unit, a signal detector and/or a sensor for detecting the battery energy transfer configuration, and the configuration detection interface is an internal interface between the control and monitor means and the internal communication unit, signal detector and/or sensor.

In other words, according to this embodiment, the devices such as detectors, sensors, or internal communication unit that are capable to detect the battery configuration or to collect information by communication with an external communication unit may be part of the EVSE multichannel insulation monitoring device. It is also possible that some of these internal devices, e.g. a detector is part of the EVSE multichannel insulation monitoring device and others, such as sensors are external devices, etc.

According to an embodiment, the signal detector is configured to detect one or more of the following: a common mode signal on Control Pilot, CP, or on an MIMD channel, an interference on the DC bus, a bias applied to the DC bus, and a connector keying.

The list is not comprehensive. Further detection methods may be used to detect the battery energy transfer configuration or to contribute to detecting the configuration.

A connector keying is for example, a tab, notch or flap on the connector. That is, the detector detects the battery energy transfer configuration by detecting physical features that determine whether the line is connected or not.

The interference may lead to a voltage different from an expected voltage. The interference detector for detecting the interference may be realized, for example, by a voltage comparator. For the typical IMD, if more than one IMD measurement voltage is injected on one channel, the resulting interference will result in unusable IMD measurements. However, if the expectation of interference is designed into the function of the IMD, interference can be used to determine the required monitoring configuration.

According to an embodiment, the control and monitor means are configured to monitor the insulation monitoring or earth leakage current during a precharge phase, cable check and/or a charging phase.

According to a further aspect, an EVSE multichannel insulation monitoring device arrangement comprising a plurality of EVSE insulation monitoring devices is provided, wherein each EVSE insulation monitoring device comprises a monitoring channel, and each of the EVSE insulation monitoring devices has control and monitor means configured to monitor the insulation or earth leakage current of the monitoring channel for an EV energy transfer session according to a current battery energy transfer configuration either individually or coordinated with each other depending on the current battery energy transfer configuration.

According to an embodiment, the EVSE multichannel insulation monitoring device arrangement further comprises a common controller configured to assign a monitoring channel of the multiple monitoring channels individually to a DC bus and to monitor each DC bus individually in case the battery configuration is such that each DC bus is connected to a separate battery or coordinated in case the battery configuration is such that more than one DC bus is connected to a single battery.

According to a further aspect, an EVSE comprising an EVSE multichannel insulation monitoring device as described herein is provided.

According to a further aspect, a method for insulation monitoring or earth leakage current monitoring performed by an EVSE multichannel insulation monitoring device comprises multiple monitoring channels as described herein is provided. The method comprises the steps: Receiving information about a battery energy transfer configuration, and selecting at least one monitoring channel of the multiple monitoring channels in dependence on the information about a battery energy transfer configuration.

The method may comprise more steps corresponding to the described embodiments. For example, the method may comprise detecting a change of the battery enegery transfer configuration, wherein the change includes switching two DC buses to a single battery, and selecting only one monitor channel to monitor only one of the two DC buses. In another example, vice versa, if the change includes switching two buses to separate batteries instead of a single battery, the method step may comprise monitoring each of the DC buses thorugh two independent monitoring channels.

According to a further aspect a use of an EVSE multichannel insulation monitoring device as described herein comprising multiple monitoring channels for insulation monitoring or earth leakage current monitoring is provided.

These and other features, aspects and advantages of the present invention will become better understood with reference to the accompanying figures and the following description.

### Short Description of the Figures

- Fig. 1: shows a high-level diagram of an connector.
- Fig. 2: shows an annotated minimalist component diagram used in Figs. 3A to 3E.
- Figs. 3A to 3E: show diagrams with different battery energy transfer configurations
- Fig. 4: shows a block diagram of an EVSE and EV in a first battery energy transfer configuration.
- Fig. 5: shows a block diagram of an EVSE and EV in a second battery energy transfer configuration.
- Fig. 6: shows a block diagram of an EVSE and EV in a third battery energy transfer configuration.
- Fig. 7: shows a block diagram of an EVSE and EV in a fourth battery energy transfer configuration.
- Fig. 8: shows a diagram with an example of monitoring activity of the MIMD during successive charging phases.
- Fig. 9: shows a flow diagram a method for insulation monitoring or earth leakage current monitoring.

### Detailed Description of Embodiments

Corresponding parts are provided with the same reference symbols in all figures.

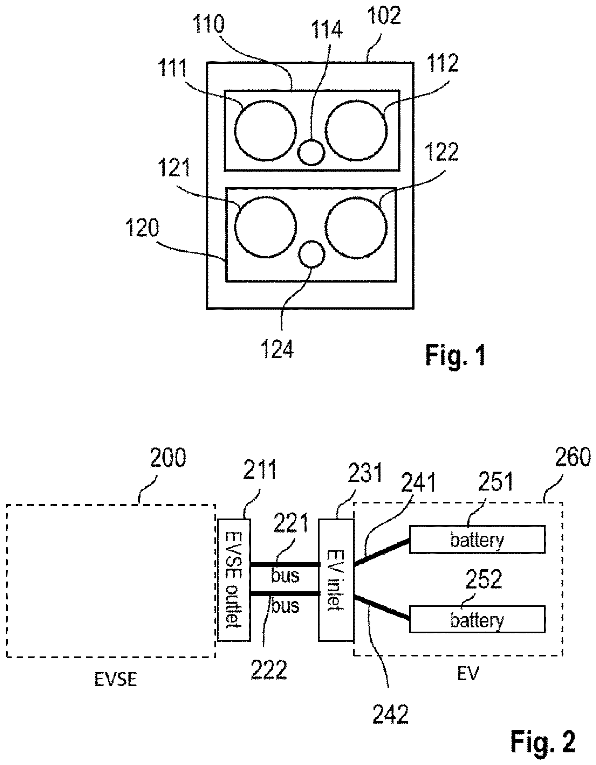

Fig. 1 shows an high-level diagram of dual DC pin connector 102. The shown connector is an illustrative example of a connector to which the EVSE multichannel insulation monitoring device proposed herein may be applied. The connector 102 has two DC buses 110, 120, each with at least a DC+ pin 111, 121, a DC- pin 112, 122, and a PE pin 114, 124. The connector provides further connections such as communication signals and various further signals such as control signals, which are not shown in Fig. 1.

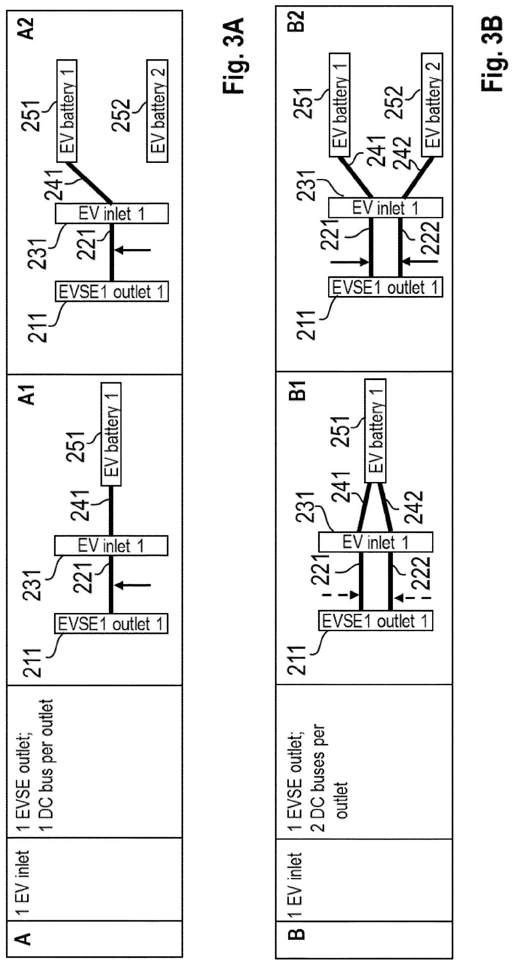

Fig. 2 shows an exemplary diagram of a battery energy transfer configuration. The battery energy transfer configuration shown includes one EVSE outlet 211, one EV inlet 231 and two DC-buses 241, 242, i.e., a first 241 and a second 242 DC bus, from the EVSE outlet 211 to the EV inlet 231. There is a connection 241 of the first DC bus 221 at the EV inlet 231 to a first battery 251, and a connection 242 of the second DC bus 222 at the same EV inlet 231 to a second battery 252. These connections 241 and 242 are also part of the respective DC buses 221 and 222. That is, there are two separate DC buses 221/241 and 222/242, where each DC bus 221/241, 222/242 is connected to a respective battery 251, 252. The batteries 251, 252 are located inside the EV 260, and the EV inlet 231 forms the DC interface at the EV 260 towards the EV 260, whereas the EVSE outlet 211 forms the DC interface at the EVSE 200 towards the EV 260. The components shown exemplarily in Fig. 2 are used in Table in Figs. 3A to 3E.

Figs. 3A to 3E show a table and diagrams with possible combinations of EV inlets, EVSE outlets, DC buses per outlet and EV batteries. The combinations include different numbers of inlets, outlets, DC buses and batteries. The first column indicates the number of inlets, the second column the number of ESVE outlets and buses, as well as the number of buses per outlet. In the third column, diagrams are shown where a vehicle has one battery and in the third column, diagrams are shown where a vehicle has two batteries. The configuration can of course be extended accordingly to more than one or two of each of the components, i.e., for example, more than two inlets, outlets, batteries, etc. The lines 221-224, and 241-243 indicate the connection of DC buses between the EVSE outlet and the EV inlet, and the EV inlet and the batteries, respectively. The full lined arrows indicate that there is no interference when monitoring the DC buses. The dashed arrows indicate that there might occur interference when monitoring the DC buses, which is impeded by the EVSE multichannel insulation monitoring device as described herein.

Fig. 3A shows the diagrams for a configuration A with one EV inlet 231, one EV outlet 211, and one DC bus 221/241 per outlet, i.e. one DC bus 221/241. Interference will occur neither in the one-battery case A1 nor in the two-batteries case A2 since there is only one DC bus 221/241. In configuration A2, the second battery 252 is not connected to the DC bus 221/241. In both cases, the MIMD selects one channel for monitoring the DC bus 221/241.

Reference signs as for example 221/241 or 222/242 relate to a first DC bus with parts 221 and 241, and to a second DC bus 222/242 with parts 222 and 242. In some example configurations, the parts 241 and 242 are not avaible so that the DC buses consist only of parts 221 or 222, respectivley. This scheme is applied also to further DC buses.

Fig. 3B shows the diagrams for a configuration B with one EV inlet 231, one EV outlet 211, and two DC buses 221/241, 222/242 per outlet. Both DC buses 221/241, 222/242 are conducted in configuration B1 via the inlet 231 to one battery 251, such that interference might be caused. In configuration B2, each DC bus 221/241, 222/242 is conducted to a respective battery 251, 252, such that no interference will occur. In the one-battery case B1, the MIMD control and monitor means select one channel for insulation monitoring. The monitoring may be performed on DC bus 221/241 or DC bus 221/242. The respective other DC bus then is monitored indirectly. I.e., if the expected voltage on the DC bus does not correspond to the expected one, the reason may be a leakage or insulation defect on DC bus 221/241 or in DC bus 222/242. That is, as both DC buses are connected to the battery 251, the buses are detected or monitored as a single bus by the MIMD, so a fault in one of the them will be detected by the MIMD.

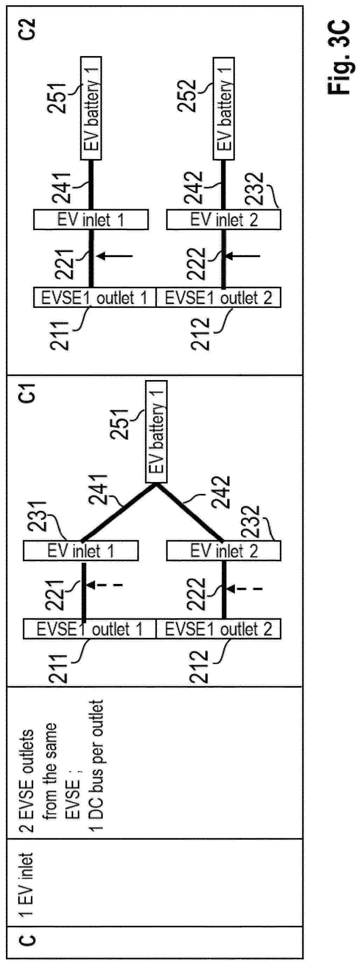

Fig. 3C shows the diagrams for a configuration C with two EV inlets 231 and 232, two EV outlets 211, 212 from the same EVSE, and two DC buses 221/241, 222/242, i.e., one DC bus per outlet. Since in configuration C1, both DC buses 221/241, 222/242 are connected to the same battery 251, interference may occur such that the MIMD control and monitor means selects one channel for either monitoring the DC bus 221/241 or the DC bus 222/242. In configuration C2, the first DC bus 221/241 is connected to the first battery 251, and the second DC bus 222/242 is connected to the second battery 252. No interference will occur. The MIMD control and monitor means will select one channel for monitoring the first DC bus 221/241, and a second channel for monitoring the second DC bus 222/242.

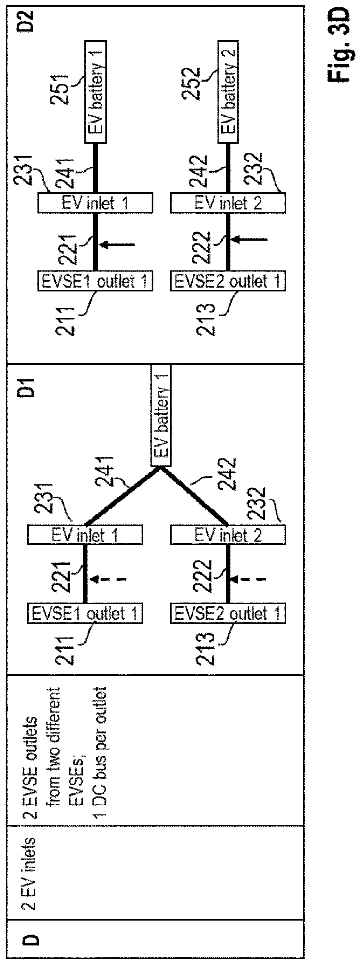

Fig. 3D shows the diagrams for a configuration D with two EV inlets 231, 232, two EV outlets 211, 213 from different EVSEs, and two DC buses 221/241, 222/242, i.e., one DC bus per outlet. In configuration D1, again both DC buses 221/241, 222/242 are connected to the same battery 251 such that interference might occur and the MIMD control and monitor means select a channel for monitoring the DC bus 221/241. The control and monitor means may have means to detect an interference or to detect the signal characteristics of the IMD of the other EVSE. The control and monitor means may also detect that there is no interference. This may be the case, if the signal provided to the buses 221/241 differs from the signal, e.g. by using a different frequency. In this case, it would also be possible to monitor both DC buses 221/241, 222/242. In configuration D2, the first DC bus 221/241 is again connected to the first battery 251, and the second DC bus 222/242 is connected to the second battery 252. No interference will occur. The MIMD control and monitor means will select one channel for monitoring the first DC bus 221/241. Since the EVSE might be a device of another provider, the second DC bus 222/242 may be monitored independently by an IMD of the EVSE of the other provider.

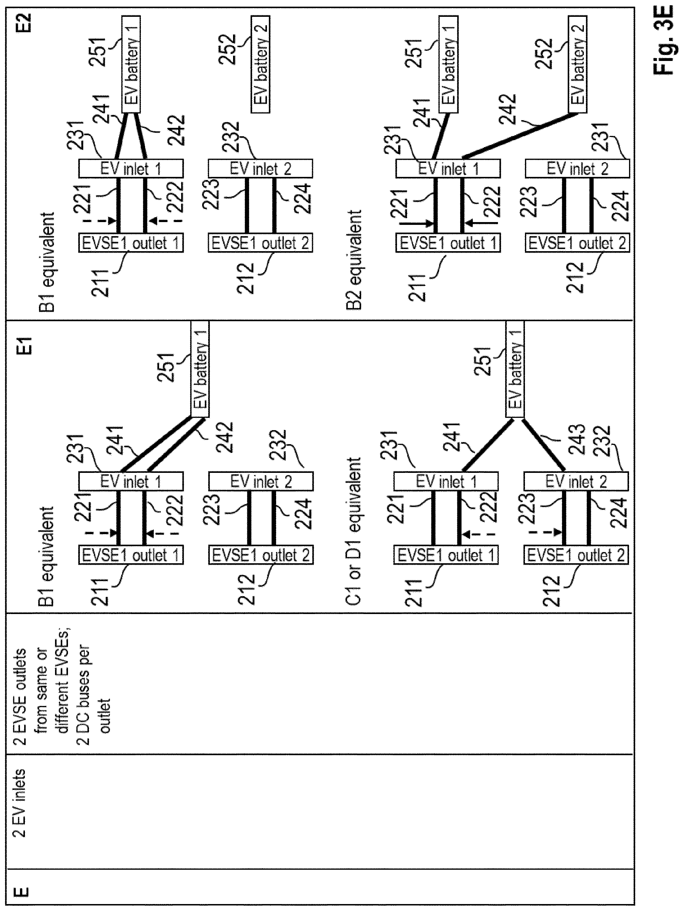

Fig. 3E shows the diagrams for a configuration E with two EV inlets 231, 232, two EV outlets 211, 212 from different or same EVSEs, two DC buses 221, 222 for outlet 211, and two DC buses 223, 224 for outlet 212, i.e., two DC buses per outlet. In the one-battery case E1, two sub-configurations are shown. In the first sub-configuration, two DC buses 221/241, 222/242 are connected to the same battery 251 such that interference might occur and the MIMD control and monitor means will select one channel for monitoring the first DC bus 221/241 and the second DC bus 222/242. In the second sub-configuration, also two DC buses 222/241, 223/243 are connected to the same battery 251 such that interference might occur and the MIMD control and monitor means will select one channel for monitoring the first DC bus 221/241 and the second DC bus 223/243. The first sub-configuration corresponds to configuration B1, and the second sub-configuration corresponds to configuration C1 or D1.

In the first sub-configuration of the two-battery case E2, two DC buses 221/241, 222/242 are connected to the same battery 251 such that interference might occur and the MIMD control and monitor means will select one channel for monitoring the first DC bus 221/241 and the second DC bus 222/242. The second battery 252 is not is connected. This sub-configuration corresponds to configuration B1. In the second sub-configuration of the two-battery case E2, the first DC bus 221/241 is connected to the first battery 251, and the second DC bus 222/242 is connected to the second battery 252. No interference will occur. The MIMD control and monitor means will select one channel for monitoring the first DC bus 221/241, and a second channel for monitoring the second DC bus 222/242.

Summarized, one DC bus must be monitored for each battery that is connected to an EVSE. Interference is possible any time the number of active DC buses in the system is greater than the number of batteries being charged.

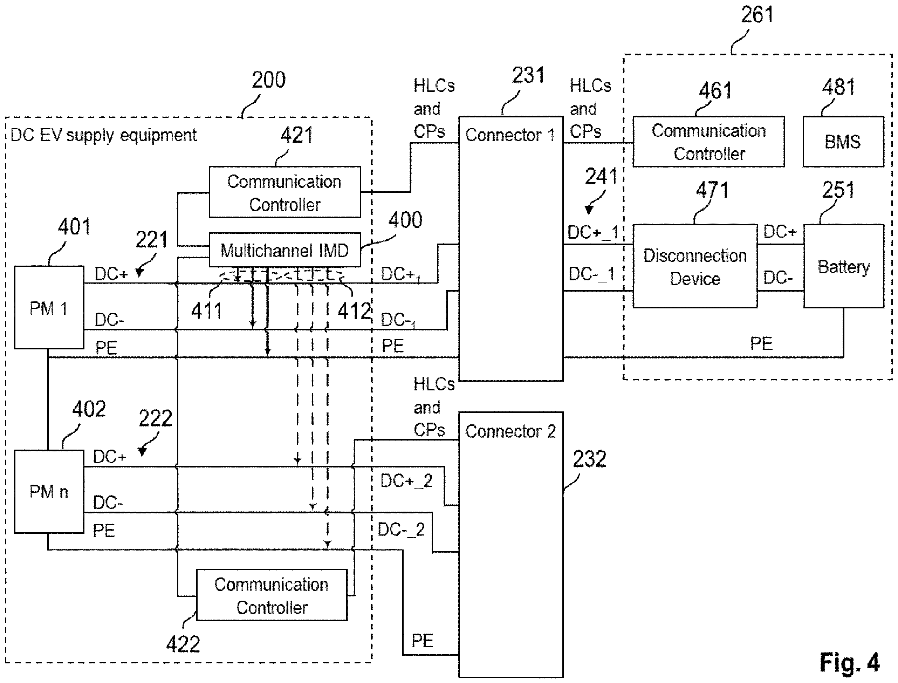

Figs. 4-7 illustrate how the MIMD 400 would solve a selection of scenarios from the Table in Fig. 3. These solutions can be abstracted for all other combinations of EV batteries, EVSEs, DC buses, and EVSE outlets/ EV inlets. A maximum of two batteries, or EVs, or outlets are shown below for ease of understanding, but the MIMD described here is equally applicable for more than two of each element.

Fig. 4 shows in a block diagram, how the MIMD 400 can monitor a situation according to configuration A1 as illustrated in Fig. 3A with one active outlet provided by power module (PM) 401 that is connected via one DC bus 221 and connector or inlet 231 to a single battery 251. That is, the DC bus 221 to be monitored with lines DC+, DC- and PE between power module 401 and connector 231 is further lead as DC bus 241 to the first electric vehicle 261 to charge the battery 251 or to receive energy from the battery 251. The first electric vehicle 261 further contains a battery management system (BMS) 481 and a disconnection device 471 to disconnect the battery 251 from the DC bus 241, for example, when the charging of the battery 251 is completed. The communication controllers 421, 422, 461 are responsible for the High-Level-Communication (HLC) and the Control Pilot signal (CP). For example, the standard IEC 61851-23 defines as a requirement for DC charging for different systems, e.g., using an IPv6-based protocol structure and power line communication (PLC) technology over dedicated pins, such as CP and PE in CCS. The MIMD 400 is connected to communication controller 421, which is connected to communicaton controller 461 of the vehicle 261, and to the second communication controller 422 of the EVSE. The communication controller may be one information source for obtaining information about the battery energy transfer configuration of the vehicle, for example, how many batteries are available in the vehicle, whether they are connected to the DC bus 241 for charging, whether the inlet is connected mechanically and/or electrically to the connector(s) 231, 232, information about the charging phase, e.g. pre-charging, start of charging, charging completed, etc. In the shown configuration that corresponds to the configuration A1 of Fig. 3A, the MIMD selects one channel 411 for monitoring the DC bus 221 with the DC+, DC- and PE lines based on the information received from the communication controllers 421 and 422. The channel 412 for the DC bus 222 is deactivated or not used.

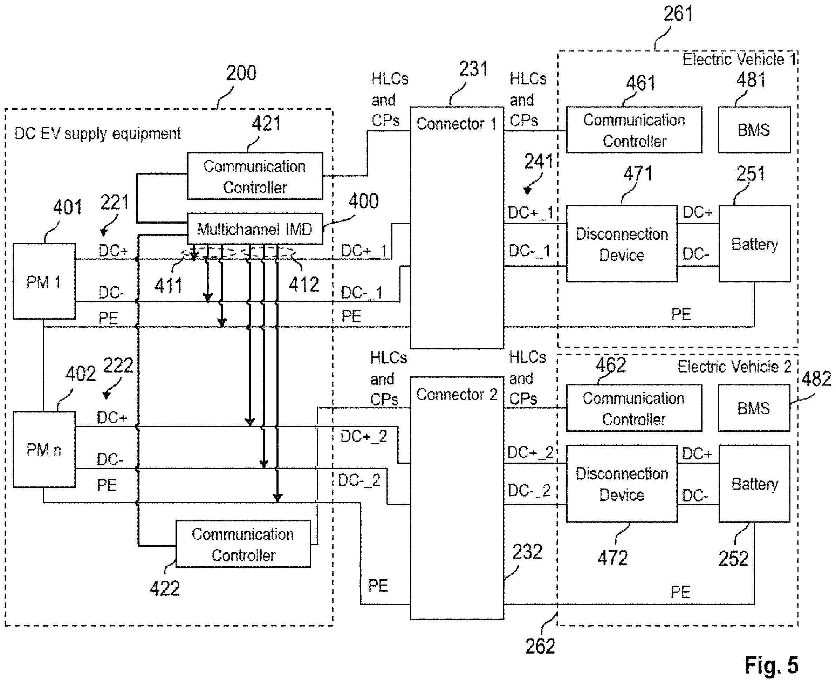

Fig. 5 shows in a further block diagram, how the MIMD 400 can monitor a situation according to configuration C2 as illustrated in Fig. 3C with two active EVSE outlets 211, 212 provided by power modules 401 and 402, each of which is connected to a respective DC bus 221, 222 and to connectors 231, 232 or inlets 231, 232, and to batteries 251, 252. A single EVSE 200 with two outlets will require insulation monitoring on each bus when each outlet is transferring energy to or from a separate EV 261, 262. In addition, insulation monitoring is necessary on each bus during cable check and other phases of the energy transfer session. Fig. 5 shows a possible configuration for both of these scenarios. Additionally to the blocks in Fig. 4, there is a second electrical vehicle 262 with battery 452, communication controller 462, disconnection device 472, and BMS 482 with the same functionalities as the ones of the first electrical vehicle 261. Through the controller, the MIMD 400 obtains the information about the battery energy transfer configuration including their connection with the DC buses 221/241 and 222/242. The MIMD 400 determines that the DC buses 221/241 and 222/242 are separated from each other, and that they are connected separately to batteries 251 and 252. Therefore, they do not interfere with each other. The MIMD 400 then selects one channel 411 for monitoring the DC bus 221/241, and one channel 412 for monitoring the DC bus 222/242. The channel 412 is independent from channel 411.

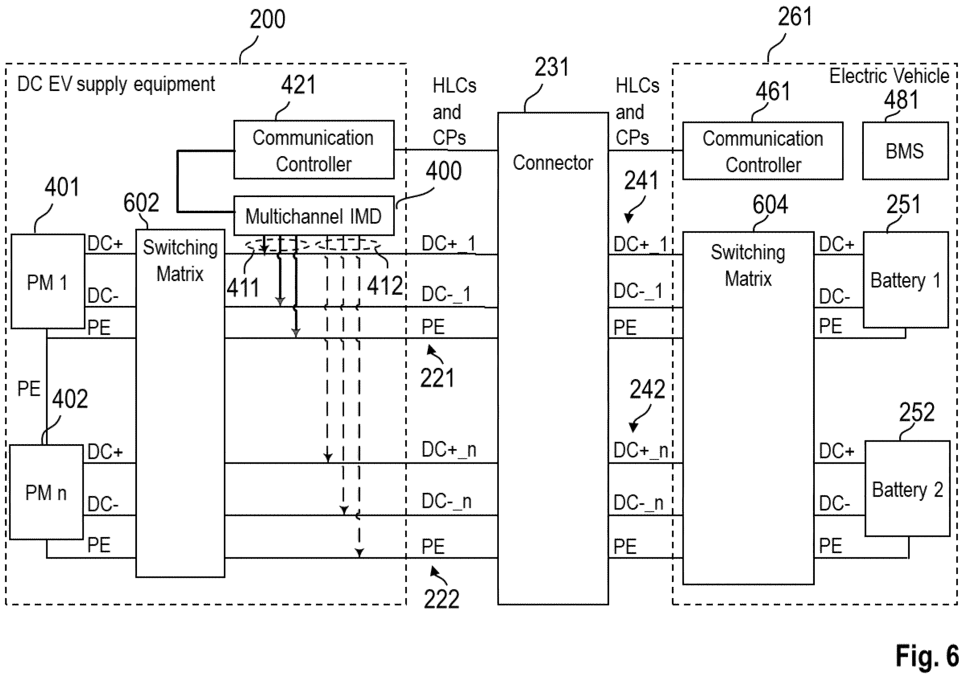

Fig. 6 shows in a further block diagram a configuration with one EVSE 200 and one outlet and two DC buses realized by power modules 401 and 402, and by the switching matrix 602, from which the two DC buses 221/241 and 222/242 lead to connector 231 and further to switching matrix 604, realizing two inlets. The switching matrix 604 in the example of Fig. 6 connects the two DC buses 241 and 242 to the battery 251 only. The configuration of Fig. 6 corresponds to the configuration B1 of Fig. 3B. If measurements on two channels were performed at the same time, the measurements might interfere with each other. Therefore, the MIMD 400, which is aware of the configuration due to the input from communication controller 421, selects only one channel 411, which will be associated with DC bus 221/241. In Fig. 6, channel 411 is selected, however, the MIMD 400 may also select channel 412, which will be associated with DC bus 222/242.

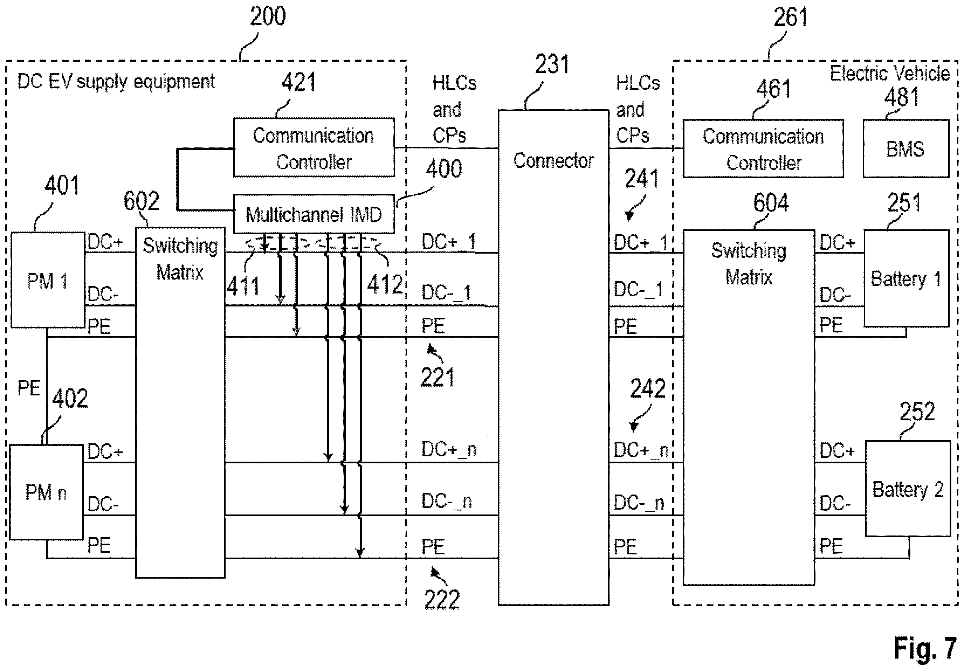

Fig. 7 shows in another block diagram a configuration similar to Fig. 6, however the switching matrix 604 directs energy to both, the first battery 511 and the second battery 252. In more detail, the configuration is characterized by one EVSE 200 and one outlet and two DC buses 221, 222, realized by power modules 401 and 402, and by the switching matrix 602, from which the two DC buses 221 and 222 lead to connector 231 and further as buses 241, 242 to switching matrix 604, realizing two inlets. The switching matrix 604 in the example of Fig. 7 connects the DC bus 241 to the first battery 251 and the DC bus 242 to the second battery 252. The configuration of Fig. 7 corresponds to the configuration B2 of Fig. 3B. The MIMD 400 selects a first channel 411, which will be associated with DC bus 221/241, and a seond channel 412, which will be associated with DC bus 222/242. The measurements on the two channels 411, 412 do not interfere with each other.

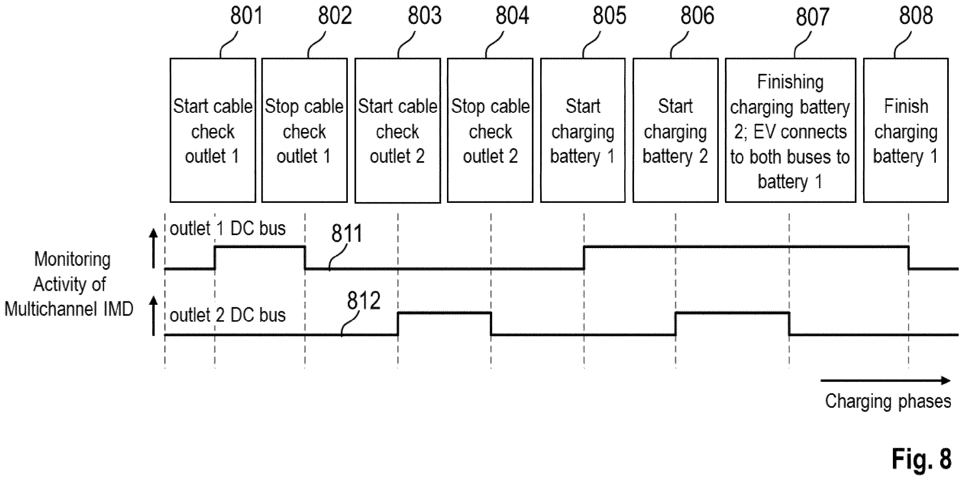

Fig. 8 shows a process diagram of a possible implementation. The EVSE 200 will update the monitoring configuration if the battery energy transfer configurations change. For example, considering an EVSE with two outlets, one DC bus on each outlet, charging two separate batteries in one EV. During cable checks between start cable checks 801, 803 and respective stop cable checks 802, 804, the MIMD behavior is checked on both outlets, not necessarily at the same time as indicated by the lines 811 and 812. Line 811 shows that the activity state of the monitoring channel monitoring the DC bus of outlet 1 is "high" between the phases "start cable check outlet 1" 801 and "stop cable check outlet 1" 802. Line 812 shows that the activity state of the monitoring channel monitoring the DC bus of outlet 2 is "high" between the phases "start cable check outlet 2" 803 and "stop cable check outlet 2" 804. During charging battery 1 in the phase between the events start charging battery 1 805 and stop charging battery 1 807 and charging battery 2 in the phase between events start charging battery 2 806 and stop charging battery 2 807, both separate buses are monitored by the MIMD 400. If one battery reaches a full state and the charging of e.g., battery 2 is finished at event 807 in Fig. 8, the EV may connect the two DC buses in parallel, directing the power from both to the one remaining battery, in Fig. 8 to battery 1. The MIMD will recognize this change via one of the mechanisms described above, and it will adjust such that it is active on only one of the two connected DC buses, as indicated by the lines 811 and 812 between the events 807 and 808.

The MIMD could also employ a mechanism such as using different frequencies or different shapes of injected voltage per bus. With this approach there would be MIMD activity on all of the buses, but only the MIMD measurements from one bus per battery would be considered in the insulation monitoring.

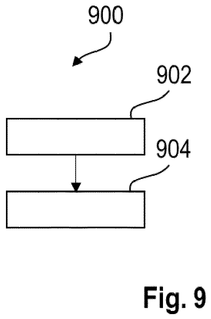

Fig. 9 shows a method 900 for insulation monitoring or earth leakage current monitoring performed by an EVSE multichannel insulation monitoring device as described herein that comprises multiple monitoring channels. The method comprising the following steps: receiving 902 information about a battery energy transfer configuration; selecting 904 at least one monitoring channel of the multiple monitoring channels in dependence on the information about a battery energy transfer configuration.

Other variations to the disclosed embodiments can be understood and effected by those skilled in the art in practicing the claimed invention, from the study of the drawings, the disclosure, and the appended claims. In the claims, the word "comprising" does not exclude other elements or steps and the indefinite article "a" or "an" does not exclude a plurality. A single processor or other unit may fulfill the functions of several items or steps recited in the claims. The mere fact that certain measures are recited in mutually different dependent claims does not indicate that a combination of these measures cannot be used to advantage. Any reference signs in the claims should not be construed as limiting the scope of the claims.

### List of Reference Numerals

- 102: DC pin connector
- 110: first DC bus
- 111: DC+ pin of first DC bus
- 112: DC- pin of first DC bus
- 114: PE pin of first DC bus
- 120: second DC bus
- 121: DC+ pin of second DC bus
- 122: DC- pin of second DC bus
- 124: PE pin of second DC bus
- 200: EVSE
- 211: EVSE 1 outlet 1
- 212: EVSE 1 outlet 2
- 213: EVSE 2 outlet 1
- 221: first DC bus between EVSE 1 outlet 1 and EV inlet 1
- 222: second DC bus between EVSE 1 outlet 1 or 2 and EV inlet 1 or 2
- 223: first DC bus between EVSE 1 outlet 2 and EV inlet 2
- 224: second DC bus between EVSE 1 outlet 2 and EV inlet 2
- 231: EV inlet 1 / Connector 1
- 232: EV inlet 2 / Connector 2
- 241: first DC bus between EV inlet 1 and EV battery 1
- 242: second DC bus between EV inlet 1 or 2 and EV battery 1 or 2
- 243: first DC bus between EV inlet 2 and EV battery 1
- 251: EV battery 1
- 252: EV battery 2
- 261: first electric vehicle
- 262: first electric vehicle
- 400: multichannel IMD, MIMD
- 401: power module 1
- 402: power module 2
- 411: first monitoring channel
- 412: second monitoring channel
- 421: MIMD control and monitor means, first EVSE communication controller
- 422: MIMD control and monitor means, second EVSE communication controller
- 461: EV communication controller of EV 1
- 462: EV communication controller of EV 2
- 471: disconnection device of EV 1
- 472: disconnection device of EV 2
- 481: battery management system BMS of EV 1
- 482: battery management system BMS of EV 2
- 801...808: events defining charging phases
- 811: monitoring activity regard outlet 1 DC bus
- 812: monitoring activity regard outlet 2 DC bus
- 900: method
- 902: first method step
- 904: second method step

## Claims

1. Electric Vehicle Supply Equipment, EVSE, multichannel insulation monitoring device, MIMD, (400) for insulation monitoring or earth leakage current monitoring, wherein the EVSE multichannel insulation monitoring device (400) comprises multiple monitoring channels (411, 412) and wherein the EVSE multichannel insulation monitoring device (400) has control and monitor means (421, 422) configured to individually monitor the insulation or earth leakage current of each monitoring channel (411, 412).

2. EVSE multichannel insulation monitoring device (400) according to claim 1, wherein, for individually monitoring the insulation or earth leakage current during a EV energy transfer session, the control and monitor means (421, 422) are configured to assign a monitoring channel (411, 412) of the multiple monitoring channels (411, 412) individually to a DC bus (221/241, 222/242) and to monitor each DC bus individually in case the battery configuration is such that each DC bus is connected to a separate battery or coordinated in case the battery configuration is such that more than one DC bus is connected to a single battery.

3. EVSE multichannel insulation monitoring device (400) according to claim 1 or 2, wherein the EVSE multichannel insulation monitoring device (400) has a battery energy transfer configuration detection interface for receiving information about the battery energy transfer configuration, wherein control and monitor means (421, 422) are further configured to determine the battery energy transfer configuration and select the monitoring channels (411, 412) according to the received information about the battery configuration.

4. EVSE multichannel insulation monitoring device (400) according to claim 3, wherein the receiving information may be obtained as control commands, communication signals, detector signals and/or sensor signals.

5. EVSE multichannel insulation monitoring device (400) according to any of claims 3 to 4, wherein the control and monitor means (421, 422) are configured, in case control and monitor means (421, 422) have determined a configuration with more than one DC bus connected to a battery for charging the battery, to coordinate the monitoring between the channels.

6. EVSE multichannel insulation monitoring device (400) according to claim 5, wherein the coordinating of the monitoring between the channels includes selecting one of the monitoring channels (411, 412) for monitoring one of the DC buses.

7. EVSE multichannel insulation monitoring device (400) according to any one of the previous claims, wherein the configuration detection interface is an interface to a controller, a communication unit, an interference detector and/or sensor, wherein the controller, the communication unit, the interference detector and/or the sensor are external to the EVSE multichannel insulation monitoring device (400).

8. EVSE multichannel insulation monitoring device (400) according to claims 2 or 3, wherein the EVSE multichannel insulation monitoring device (400) comprises further an internal communication unit for communicating with the external communicating unit, a signal detector and/or a sensor for detecting the battery energy transfer configuration, and the configuration detection interface is an internal interface between the control and monitor means (421, 422) and the internal communication unit, signal detector and/or sensor.

9. EVSE multichannel insulation monitoring device (400) according to claim 7 or 8, wherein the signal detector is configured to detect one or more of
a common mode signal on Control Pilot (CP), or on an MIMD (400) channel,
an interference on the DC bus,
a bias applied to the DC bus,
a connector keying.

10. EVSE multichannel insulation monitoring device (400) according to any one of the previous claims, wherein the control and monitor means (421, 422) are configured to monitor the insulation monitoring or earth leakage current during a precharge phase, cable check and/or a charging phase.

11. EVSE multichannel insulation monitoring device (400) arrangement comprising a plurality of EVSE multichannel insulation monitoring devices (400) wherein each EVSE multichannel insulation monitoring device (400) comprises a monitoring channel (411, 412), and each the EVSE multichannel insulation monitoring device (400) has control and monitor means (421, 422) configured to monitor the insulation or earth leakage current of the monitoring channel (411, 412) for an EV energy transfer session according to a current battery energy transfer configuration either individually or coordinated with each other depending on the current battery energy transfer configuration.

12. EVSE multichannel insulation monitoring device (400) arrangement according to claim 11, wherein the EVSE multichannel insulation monitoring device (400) arrangement further comprises a common controller configured to assign a monitoring channel (411, 412) of the multiple monitoring channels (411, 412) individually to a DC bus and to monitor each DC bus individually in case the battery configuration is such that each DC bus is connected to a separate battery or coordinated in case the battery configuration is such that more than one DC bus is connected to a single battery.

13. EVSE comprising an EVSE multichannel insulation monitoring device (400) according to any one of claims 1 to 10.

14. Method for insulation monitoring or earth leakage current monitoring performed by an EVSE multichannel insulation monitoring device (400) comprises multiple monitoring channels (411, 412) according to any one of claims 1 to 10 comprising the steps:
Receiving information about a battery energy transfer configuration;
Selecting at least one monitoring channel (411, 412) of the multiple monitoring channels (411, 412) in dependence on the information about a battery energy transfer configuration.

15. Use of an EVSE multichannel insulation monitoring device (400) according to any one of claims 1 to 10 comprising multiple monitoring channels (411, 412) for insulation monitoring or earth leakage current monitoring.
